# EUROPEAN PATENT SPECIFICATION

(11) **EP 1 958 328 B1**
(45) Date of publication and mention of the grant of the patent: **16.02.2011**
(21) Application number: 06834074.4
(22) Date of filing: 29.11.2006
(51) Int. Cl.: H03F 1/02, H04B 3/54, H04L 27/26

(54) **SIGNAL OUTPUT CIRCUIT, COMMUNICATION APPARATUS AND SIGNAL OUTPUT CONTROL METHOD**
SIGNALAUSGABESCHALTUNG, KOMMUNIKATIONSVORRICHTUNG UND SIGNALAUSGABESTEUERVERFAHREN
CIRCUIT DE SORTIE DE SIGNAL, APPAREIL DE COMMUNICATION ET METHODE DE COMMANDE DE SORTIE DE SIGNAL ASSOCIEE

(30) Priority: 29.11.2005 JP 2005344262
(43) Date of publication of application: 20.08.2008
(73) Proprietor: Panasonic Corporation, Kadoma-shi Osaka 571-8501 (JP)
(72) Inventor: ICHIHARA, Fumio, c/o Matsushita Electric Industrial Co., Ltd, Osaka, 540-6207 (JP)
(74) Representative: Eisenführ, Speiser & Partner
(86) International application number: PCT/JP2006/324319
(87) International publication number: WO 2007/064024

(56) References cited:
- EP-A1- 1 179 937
- WO-A-03/013095
- JP-A- 2001 292 034
- US-A1- 2002 153 940
- US-A1- 2003 080 816
- US-A1- 2005 024 145

## Description

### Technical Field

The present invention relates to a signal output circuit, a communication apparatus and a signal output control method that amplify and output OFDM signals or the like used for power line communication or the like.

### Background Art

For power line communication (PLC), in which power lines, which are installed in buildings, such as a house, an office and a factory, are used for communication, OFDM (Orthogonal Frequency Division Multiplexing) signals, which are generated through OFDM modulation, are used to perform broadband communication. Since commercial power is used in households and the like, using power lines for supplying power for data transmission purposes can eliminate the need to newly install special communication wires, thereby securing a transmission path by simply plugging a communication apparatus in a power outlet.

OFDM signals have the property of preventing a signal having a peak on time domain by orthogonalizing adjacent carrier signals. However, large-amplitude signals may intermittently occur on a time domain, depending on signal status. An amplifier circuit configured to secure linearity even for large-amplitude signals at peak, which intermittently occur, is used in an analog amplifier circuit for amplifying such OFDM signals. In such an amplifier circuit, despite a small average amplitude of signals, a high voltage is needed for securing linearity at points where the amplitude is large as well. This leads to a loss in an amplifier circuit or to high power consumption, which is especially prominent in a final stage of an amplifier circuit of a transmitter to send signals.

Japanese Patent Laid-Open Publication 2001-292034 discloses a power amplifier for OFDM signal amplification that can perform power amplification of OFDM signals with reduced power consumption while securing class A operability with superior linearity against intermittently occurring the signal having a peak. Such a power amplifier for OFDM signal amplification is a power amplifier for power amplification of OFDM signals designed to: delay OFDM signals for a predetermined period; determine whether a signal level during a predetermined period of time has exceeded a predetermined level during the delayed period of time; and, when it is determined that there is such an excess, increase the power voltage to be applied to the power amplifier, so that the power voltage is higher than the power voltage to be applied when it is determined that no such excess has occurred. Such a configuration contributes to effective power amplification.

However, a complicated circuit configuration has to be used in the above-described power amplifier for OFDM signal amplification because methods are employed, in its delay circuit for delaying OFDM signals for a predetermined period, to delay read time by A/D-converting OFDM signals for storing in a digital memory, and then D/A-converting back into analog signals; or to use a broadband delay circuit for delaying OFDM signals as analog signals. Further, a signal level is determined by performing A/D conversion of OFDM signals, which are then temporarily stored in a memory for determining their level in a level determination circuit. This complicates the circuit configuration.

As described above, conventional signal output circuits constantly require a high voltage in order to secure linearity for large-amplitude signals at peak, thus posing problems of high power consumption and great circuit loss. Furthermore, in order to reduce power consumption, the power amplifier disclosed in Related Art 1 is configured to perform signal level determination by delaying a signal for a predetermined period, and to control power voltage in accordance with detection results. This complicates the circuit configuration of the power amplifier.

The US patent application US 2003/0080816 A1 describes an apparatus and method for operating driver amplifier of a line driver circuit from a lower set of power supply voltages, and from a higher set of voltages only when the amplitude of the signal being transmitted by the line driver requires it as determined by a comparator. Advantageously, this reduces the power dissipation in the line driver by operating the line amplifier the majority of the time from the lower supply voltage. A delay circuit delays the signal to be amplified sufficient to allow the transitioning of the power supply voltages provided to the amplifier hysteresis of this power supply voltage switching may also be used to further reduce power dissipation.

The European patent application EP 1 179 937 A1 describes that when a transmission-line driver circuit that transmits a signal to a transmission line is supplied with a power-supply voltage from a power-supply circuit, the value of the power-supply voltage is controlled based upon the amplitude of a signal output from the transmission-line driver circuit. For example, the maximum value of a signal input to the transmission-line driver circuit in time units delimited at fixed time periods is detected, the target value of power-supply voltage supplied to the transmission-line driver circuit is decided based upon the maximum value, and the power-supply circuit is controlled in such a manner that the target value of power supply voltage and actual value of power-supply voltage will agree.

The US patent application US 2005/0024145 A1 describes a method and apparatus for dynamically changing the biasing conditions of a voltage regulator to overcome the problems caused by various conditions. The method and apparatus includes a detector and a bias control circuit for applying bias current to the voltage regulator to compensate for a detected condition.

The US patent application US 2002/0153940 A1 describes an amplifier system with on-demand power supply boost which includes an amplifier circuit for receiving an input signal and a charge pump connected to positive and negative power supplies and having predetermined supply voltages and being responsive to the input signal for increasing beyond the predetermined supply voltages the supply voltage applied to the amplifier in response to an increase in the input signal and a tracking charge pump usable in the amplifier system which includes a charge storage device. The amplifier system further includes a unidirectional isolation device interconnecting the charge storage device and one pole of a power supply and a driver circuit responsive to an input signal and interconnected between both poles of the power supply. The power supply has predetermined power supply voltages. The amplifier system further includes a bias circuit for biasing the driver circuit to charge the charge storage device in the charge mode and in the boost mode, for increasing beyond the predetermined power supply voltages, the supply voltage supplied by the storage device to an external load in response to an increase in the input signal.

The WO application WO 03/013095 A3 is related to PLC technology. PLC technology requires, in particular, the use of amplifiers that have a sufficient level of efficiency in the entire control range of so-called OFDM signals. According to the WO 03/013095 A3, the necessary dynamic range is divided into at least two partial ranges between which soft is switched over in the limit range. To this end, the device is alternatively provided, for example, with two separating output stages or one output stage, which is connected to two supply voltages in a separating manner.

### Disclosure of the Invention

The invention relate to a signal outpout circuit according to claim 1 and a signal outpout control method according to claim 8.

### Brief Description of Drawings

Fig. 1 is a block diagram illustrating a configuration of an OFDM signal output circuit according to a first example;
Fig. 2 shows a circuit configuration illustrating specific examples of a delay unit, a comparator and a timer of the OFDM signal output circuit according to the first example;
Fig. 3 shows a circuit configuration illustrating a specific example of a voltage switcher of the OFDM signal output circuit according to the first example;
Figs. 4 (a) to 4 (d) illustrate operations of respective units of the OFDM signal output circuit according to the first example;
Fig. 5 is a block diagram illustrating a configuration of an OFDM signal output circuit according to a second example;
Fig. 6 shows a circuit configuration illustrating specific examples of a delay unit, a comparator and a timer of the OFDM signal output circuit according to the second
Figs. 7 (a) to 7 (f) illustrate operations of respective units of the OFDM signal output circuit according to the example;
Fig. 8 is a block diagram illustrating a configuration of an OFDM signal output circuit according to a third example;
Fig. 9 illustrates a process in which a power voltage is boosted by an intensifier (booster) according to the third example;
Fig. 10 shows a circuit configuration illustrating a first example of the intensifier (booster) of the OFDM signal output circuit according to the third example;
Fig. 11 shows a circuit configuration illustrating a second example of the intensifier (booster) of the OFDM signal output circuit according to the third example;
Figs. 12 (a) and 12 (b) illustrate operations of respective units of the OFDM signal output circuit according to the third example;
Fig. 13 is a block diagram illustrating a configuration of an OFDM signal output circuit according to a fourth example;
Fig. 14 shows a circuit configuration illustrating a specific example of an intensifier (booster) of the OFDM signal output circuit according to the fourth example;
Figs. 15 (a) to 15 (f) illustrate operations of respective units of the OFDM signal output circuit according to the fourth example;
Fig. 16 is a block diagram illustrating a configuration of an OFDM signal output circuit according to the invention embodiment;
Fig. 17 shows a circuit configuration illustrating a specific example of an intensifier (booster) and a negative power generator of the OFDM signal output circuit according to the invention embodiment;
Figs. 18 (a) to 18 (f) illustrate operations of respective units of the OFDM signal output circuit according to the invention embodiment;
Fig. 19 is an anterior perspective view of a multi-carrier communication apparatus the invention;
Fig. 20 is a rear perspective view of the multi-carrier communication apparatus the invention;
Fig. 21 is a block diagram illustrating a configuration example of an electric circuit of the multi-carrier communication apparatus the invention; and
Fig. 22 is a block diagram illustrating functional configuration examples of a transmitter and a receiver of a power line communication apparatus including the OFDM signal output circuit.

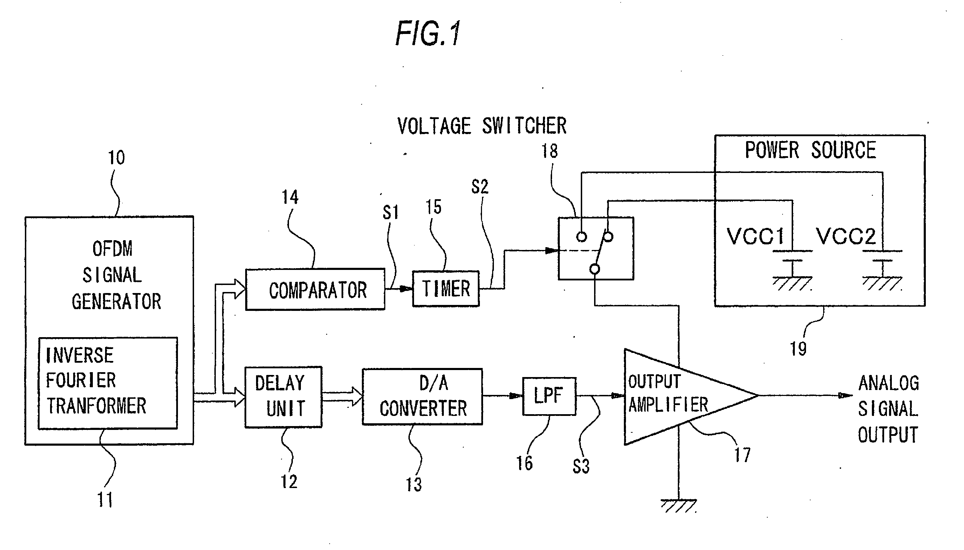

The OFDM signal output circuit described in the first example as shown in Fig. 1, includes: OFDM signal generator 10, which includes inverse Fourier transformer 11; delay unit 12; D/A converter 13; comparator 14; timer 15; LPF (low pass filter) 16; output amplifier 17, which corresponds to an example of an output amplifier for performing signal amplification; voltage switcher 18, which switches power voltages; and power source 19.

OFDM signal generator 10, which includes inverse Fourier transformer 11, generates time domain data containing amplitude information and phase information by performing inverse Fourier transform on frequency domain data, which are OFDM data generated through OFDM modulation. Such time domain data are supplied to delay unit 12 and comparator 14. Delay unit 12 delays time domain data for a predetermined period. Output data delayed by delay unit 12 are supplied to D/A converter 13 and converted into analog signals. Analog signals output from D/A converter 13 that are above a predetermined frequency level are filtered out by LPF 16, which passes only signals in a low-frequency, and are then supplied to output amplifier 17. Output amplifier 17 amplifies analog output signals (input signals into output amplifier 17) by a predetermined gain, which are then output as OFDM signals.

Comparator 14, which corresponds to an example of a detector, determines whether the amplitude of a signal has exceeded a predetermined value based on time domain data, and generates a detection output when the amplitude of the signal has exceeded the predetermined value. In other words, comparator 14 determines whether the amplitude of an output signal (an input signal into output amplifier 17), which corresponds to such time domain data, has exceeded the predetermined value. Timer 15, which corresponds to an example of an amplitude information output unit, generates timer outputs during a predetermined period of time starting from a point where the amplitude has exceeded a predetermined value, based on the detection output from comparator circuit 14. Such timer outputs are supplied to voltage switcher 18 as amplitude information indicating that the amplitude of an output signal is large. Timer outputs from timer 15 may be delayed vis-à-vis detection outputs from comparator circuit 14, depending on the response capabilities of timer 15. In such cases, timer outputs are output as high-level signals or the like during a timer-set period of time corresponding to a predetermined period of time starting from a point where the amplitude of an output signal has exceeded a predetermined value.

Power source 19 includes low voltage power supply VCC1 and high voltages power supply VCC2. Power output ends of such low voltage power supply VCC1 and high voltage power supply VCC2 are connected to a power input end of output amplifier 17 via voltage switcher 18. Voltage switcher 18, which corresponds to an example of a power voltage controller, has a function of switching power voltages to be supplied to output amplifier 17, in accordance with timer outputs. While no timer output is being generated, low voltage power VCC1 is supplied to output amplifier 17; and while a timer output is being generated, high voltage power VCC2 is supplied to output amplifier 17.

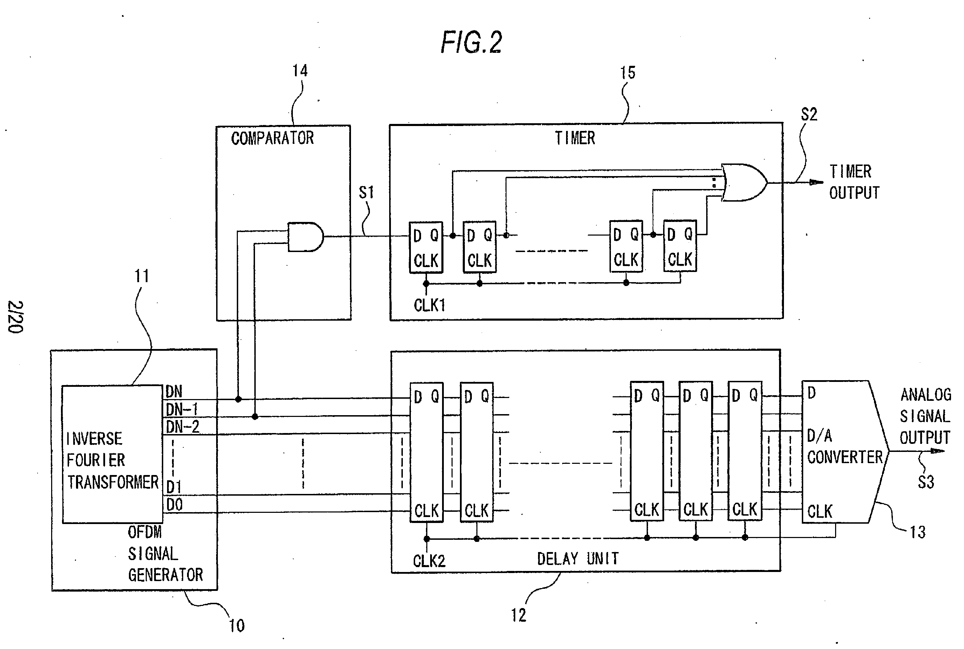

Delay unit 12 shown in Fig. 2 includes a data latch circuit, which is series-connected in multiple stages to delay time domain data to be input for a predetermined period. The delay time is set by taking into account the process time of comparator 14, timer 15 and D/A converter 13, so that an input signal into output amplifier 17 is synchronized with switching of a power voltage by voltage switcher 18. This delay time is determined by the number of stages of the data latch circuit and its clock cycle. Delay unit 12 can have other configurations than the one described above. Delay unit 12 can be configured to include a memory and a memory controller (e.g., a CPU), wherein data are read after a predetermined period following writing of data to the memory.

Comparator 14 includes an AND circuit, which performs logical AND operation on inputs. Comparator 14 decodes through logical AND operation high two bits of time domain data, which are output from OFDM signal generator 10; detects that the amplitude of an OFDM signal has exceeded a predetermined value; and generates a detection output at H level. Comparator 14 can have other configurations than the one described above. Comparator 14 can be configured to use a digital comparator to detect that the amplitude of an OFDM signal has exceeded a predetermined value.

Timer 15 includes: a data latch circuit, which is series-connected in multiple stages; and an OR circuit, which performs logical OR operation on outputs from each data latch circuit. A timer-set period of time elapsed before a timer output is generated is set at a suitable value, so that it is longer than a peak period of one unit of amplitude that may be generated in an OFDM signal. This timer-set period of time is determined by the number of stages of the data clutch circuit and its clock cycle. Timer 15 can have other configurations than the one described above and include a one-shot multi-vibrator or the like.

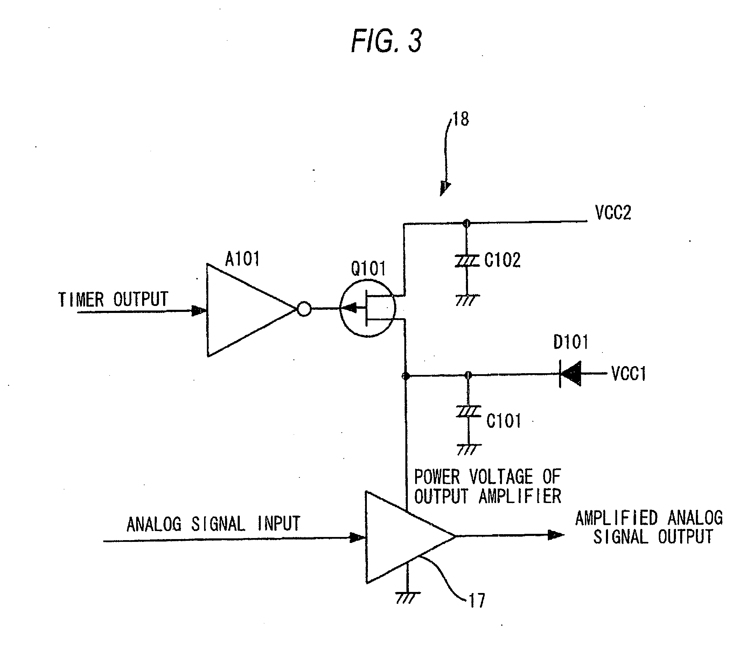

While no timer output is being generated, as shown in Fig. 3, an output from inverter A101 is at H level (high level); and field effect transistor Q101 is OFF. In this state, lower voltage power VCC1 is supplied to output amplifier 17 via diode D101. When a timer output occurs, an output from inverter A101 comes to L level (low level); field effect transistor Q101 is turned ON; and high voltage power VCC2 is supplied to output amplifier 17. Capacitors C101 and C102 are provided for voltage stabilization. Here, lower voltage power VCC1 is set so that the amplitude of an analog signal to be input into output amplifier 17 can be amplified with low distortion when it is smaller than a predetermined value. High voltage power VCC2 is set so that the amplitude of an analog signal to be input can be amplified to the maximum rated amplitude with no distortion even when the amplitude is large.

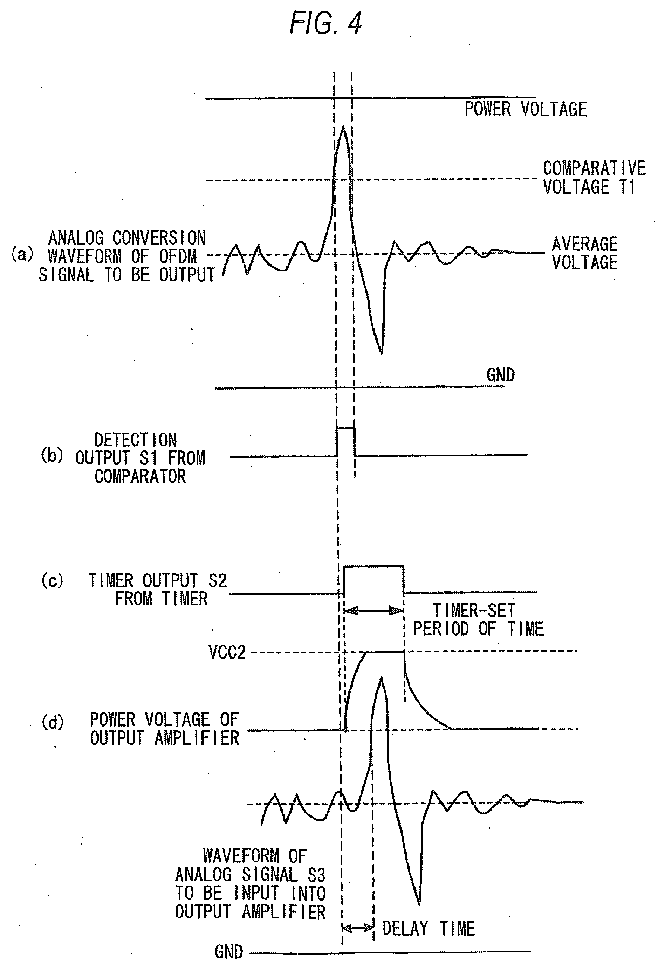

Fig. 4 (a) shows the analog conversion waveform of an OFDM signal to be output. As shown in Fig. 4 (b), comparator 14 generates detection output S1 at H level while the amplitude of an analog conversion waveform is above comparative voltage T1. As shown in Fig. 4 (c), timer 15 generates timer output S2 based on a detection output from comparator 14. For timer output S2, a timer-set period of time is indicated as ON; and the timer-set period of time corresponds to a predetermined period elapsed after the amplitude has exceeded comparative voltage T1 (predetermined value). Based on such timer output, as shown in Fig. 4 (d), voltage switcher 18 switches, only during the timer-set period of time, the power voltage of output amplifier 17 from low voltage power VCC1 to high voltage power VCC2.

Here, as shown in the lower section of Fig. 4 (d), analog signal S3 is supplied to output amplifier 17 as an OFDM signal, which is delayed by delay unit 12 for a predetermined period of time and is D/A-converted by D/A converter 13. Through the above-noted power voltage switch, the power voltage of output amplifier 17 is set high while the amplitude of an output signal is large, thereby securing a sufficient dynamic range for large-amplitude signals and maintaining linearity of an amplifier circuit.

Since OFDM signals become orthogonal signals between adjacent carriers, an amplitude peak does not usually occur. However, an amplitude peak may intermittently occur on a time domain, depending on its condition. Since one peak does not continue for a long time, a suitable timer-set period of time can be set so that the power voltage of the output amplifier is increased only during an amplitude peak period. In this case, with a simple configuration including a comparator that detects an output signal at peak and a timer that outputs a signal for switching only during a predetermined period of time in which a peak is detected, it is possible to output amplitude information indicating that an output signal has exceeded a predetermined value, thereby realizing a function of switching power voltages.

In the present example as described above, it is possible to output amplitude information indicating that the amplitude of an output signal as an OFDM signal (an input signal into the output amplifier) has exceeded a predetermined value. Further, by switching power voltages to increase the power voltage of the output amplifier during a predetermined period elapsed after an output signal has exceeded a predetermined level, a simple configuration can be used to increase the power voltage of the output amplifier only when the amplitude of an output signal is large. This makes it possible to secure linearity of the amplifier circuit even at an amplitude peak and to maintain the quality of an output signal through linear amplification. Furthermore, it is possible to reduce the power consumption of the output amplifier by increasing the power voltage of the output amplifier only while the amplitude of an output signal is large, while otherwise keeping the power voltage low.

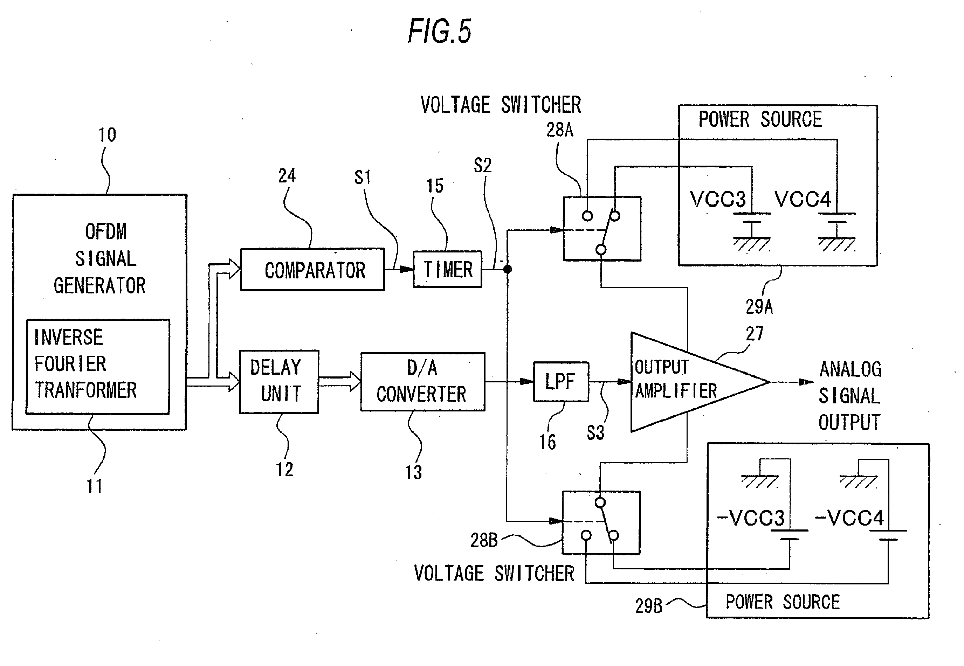

The OFDM signal output circuit described in the second example as shown in Fig. 5, includes: OFDM signal generator 10 including inverse Fourier transformer 11; delay unit 12; D/A converter 13; comparator 24; timer 15; LPF (low pass filter) 16; output amplifier 27 that is operated by positive and negative power supplies; voltage switchers 28A and 28B that switch positive and negative power voltages, respectively; and power sources 29A and 29B that supply positive and negative power voltages, respectively.

Voltage switchers 28A and 28B have a function of switching positive and negative power voltages, which are supplied to output amplifier 27, in accordance with timer outputs from timer 15. While no timer output is being generated, voltage switcher 28A supplies, to output amplifier 27, positive low voltage power VCC3 from power source 29A; and voltage switcher 28B supplies, to output amplifier 27, negative low voltage power -VCC3 from power source 29B. While a timer output is being generated, voltage switcher 28A supplies, to output amplifier 27, positive high voltage power VCC4 from power source 29A; and voltage switcher 28B supplies, to output amplifier 27, negative high voltage power -VCC4 from power source 29B.

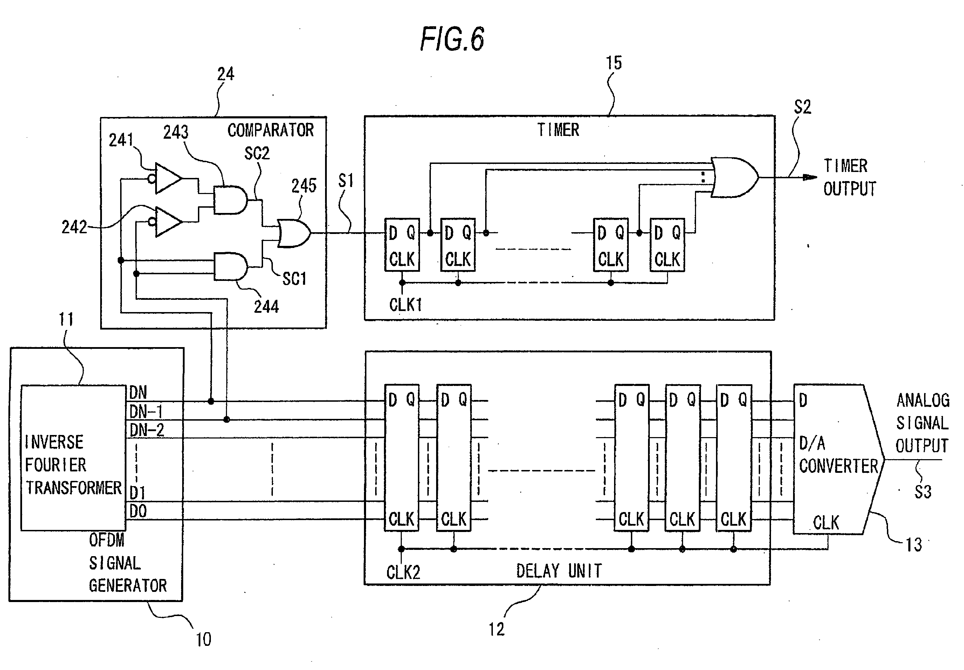

As shown in Fig. 6, comparator 24 includes: two inverters 241 and 242; two AND circuits 243 and 244; and OR circuit 245. Comparator 24 performs, in AND circuit 244, logical AND operation on high two bits of time domain data, which are output from OFDM signal generator 10; performs, in AND circuit 243, logical AND operation on the high two bits of the time domain data inverted by inverters 241 and 242; and performs, in OR circuit 245, logical OR operation on outputs from these AND circuits 243 and 244. In other words, when the high two bits of the time domain data are both at H level and when they are both at L level, it is detected that the amplitude of an OFDM signal is above a predetermined value on both positive and negative sides, and a detection output at H level is generated. The configurations of delay unit 12 and timer 15 are identical to those shown in Fig. 2.

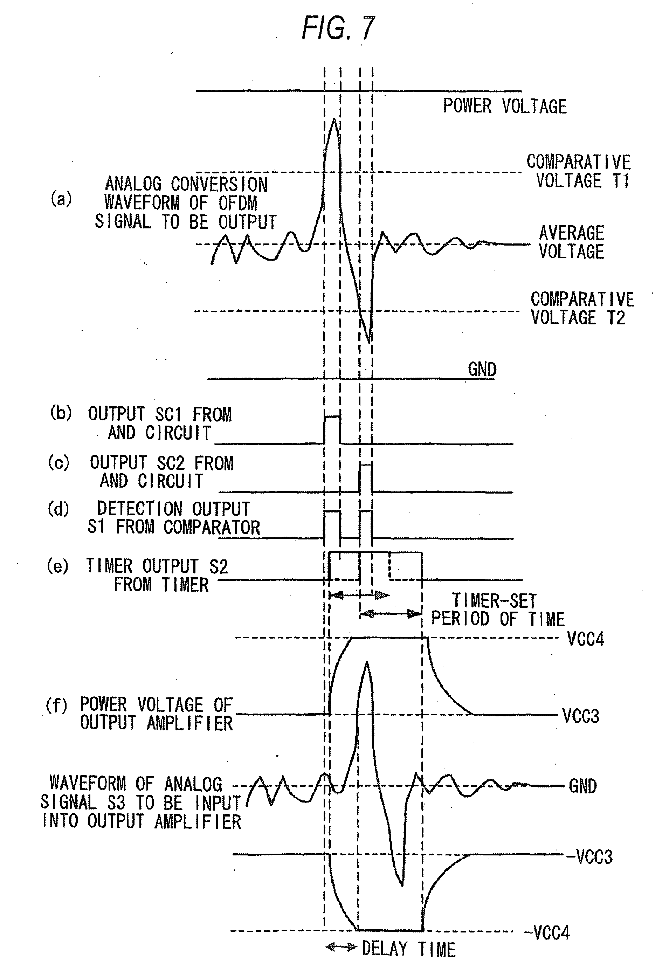

Fig. 7 (a) shows the analog conversion waveform of an OFDM signal to be output. As shown in Fig. 7 (b), AND circuit 244 of comparator 24 outputs output SC1 at H level while the amplitude of an analog conversion waveform is above comparative voltage T1. As shown in Fig. 7 (c), AND circuit 243 of comparator 24 outputs output SC2 at H level while the amplitude of an analog conversion waveform is below comparative voltage T2. As shown in Fig. 7 (d), OR circuit 245 of comparator 24 performs logical OR operation on outputs shown in Figs. 7 (b) and 7 (c); and the sum is output as detection output S1 from comparator 24.

As shown in Fig. 7 (e), timer 15 generates timer output S2 based on a detection output from comparator 24. Based on this timer output, as shown in Fig. 7 (f), voltage switchers 28A and 28B switch the power voltage of output amplifier 27 from low voltage powers VCC3 and -VCC3 to high voltage powers VCC4 and -VCC4 respectively, only during a timer-set period of time.

Here, as shown in the middle section of Fig. 7 (f), analog signal S3 is supplied to output amplifier 27 as an OFDM signal, which is delayed by delay unit 12 for a predetermined period and is D/A-converted by D/A converter 13. Through the above-noted power voltage switch, the positive and negative power voltages of output amplifier 27 are set high while the amplitude of an output signal is large, thereby securing a sufficient dynamic range for large-amplitude signals and maintaining linearity of the amplifier circuit.

In the second example as described above, as with the first example through power voltage switch in which the power voltage of the output amplifier is increased only during a predetermined period elapsed after an output signal has exceeded a predetermined level, a simple configuration can be used to increase the power voltage of the output amplifier only when the amplitude of an output signal is large. This makes it possible to secure linearity of the amplifier circuit even at an amplitude peak and to maintain the quality of an output signal through linear amplification. It is further possible to reduce the power consumption of the output amplifier by increasing the power voltage of the output amplifier only while the amplitude of an output signal is large, while otherwise keeping the power voltage low.

Further, in the second example, switching simultaneously the positive and negative power voltages of output amplifier 27 keeps the DC bias point of output amplifier 27 unchanged for large and small amplitudes, thereby preventing a shift in the operating point or an occurrence of a transient when the power voltages are switched. In regard to the waveform of an output signal, this also reduces the voltage difference between the power voltage and the voltage of the output signal waveform, both in the positive and negative amplitudes, thereby further reducing the loss in output amplifier 27.

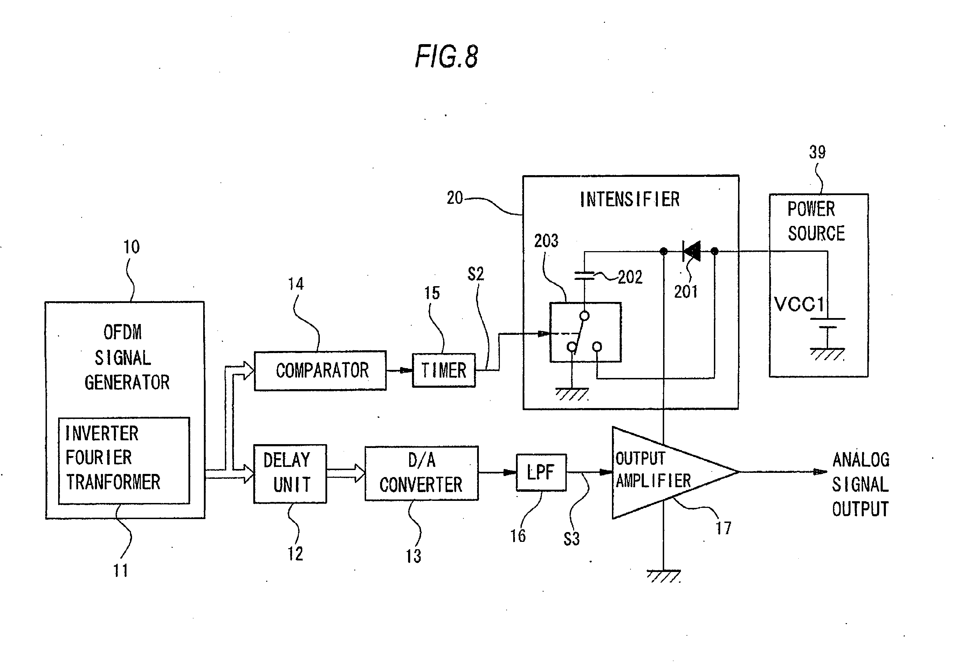

The OFDM signal output circuit described in the third example, as shown in Fig. 8, includes: OFDM signal generator 10 including inverse Fourier transformer 11; delay unit 12; D/A converter 13; comparator 14; timer 15; LPF (low pass filter) 16; output amplifier 17; power source 39; and intensifier (booster) 20.

Power source 39 includes only low voltage power supply VCC1. Intensifier (booster) 20 corresponds to an example of a power voltage controller. Intensifier (booster) 20 has a function of switching power voltages to be supplied to output amplifier 17, in accordance with timer outputs from timer 15. Intensifier (booster) 20 includes: diode 201 provided between the power terminal of output amplifier 17 and low voltage power supply VCC1; capacitor 202 connected at on end thereof to a connecting point (on a cathode side of diode 201) of the power terminal of output amplifier 17 and diode 201, the capacitor charging low voltage power VCC1, which is output from power source 39; and switching circuit 203 that switches the connection of the other end of capacitor 202 to the output of power source 39 or the ground, based on timer outputs from timer 15.

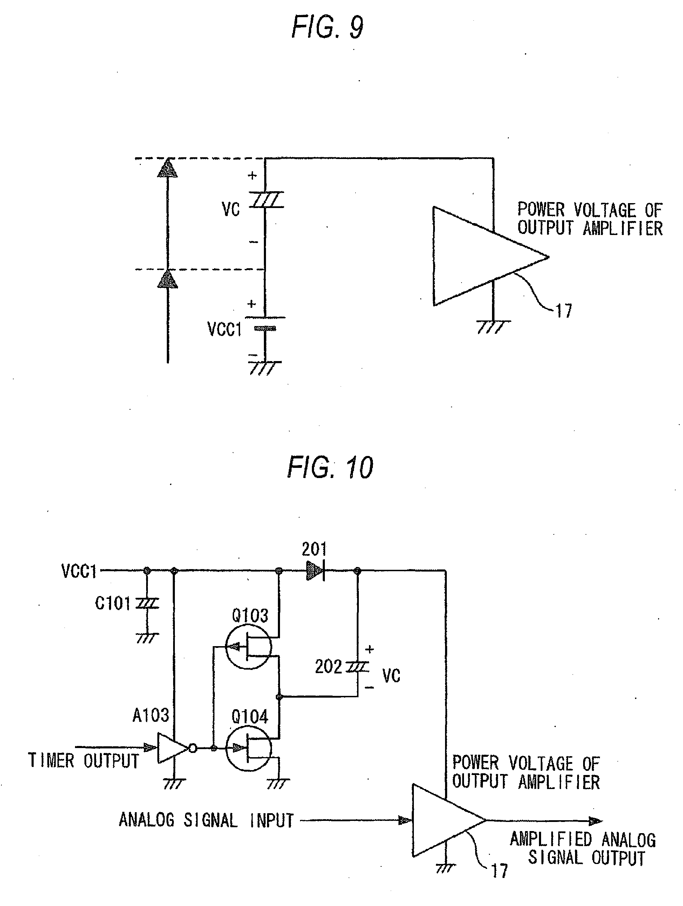

While no timer output is being generated, switching circuit 203 connects the other end of capacitor 202 to the ground potential (GND) and a power charge is provided to capacitor 202 at a voltage level derived by subtracting the forward voltage drop for diode 201 from low voltage power VCC1. Here, low voltage power VCC1 is supplied to output amplifier 17. While a timer output is being generated, switching circuit 203 connects the other end of capacitor 202 to the output of power source 39. In this configuration, the voltage charged to capacitor 202 is added to low voltage power VCC1; and, as shown in Fig. 9, the voltage boosted to power voltage VCC1+VC is supplied to output amplifier 17.

In Fig. 10, switching circuit 203 includes: inverter A103; P-channel field effect transistor Q103; and N-channel field effect transistor Q104. Low voltage power VCC1 is supplied to inverter A103 as a power source. C101 is a capacitor for power stabilization.

While no timer output is being generated, an output from inverter A103 is at H level; field effect transistor Q103 is turned OFF; field effect transistor Q104 is turned ON; and voltage VC is charged to capacitor 202. Voltage VC is at a voltage level derived by subtracting the forward voltage drop VD for diode 201 from low voltage power VCC1. In this state, low voltage power VCC1 is supplied to output amplifier 17 via diode 201. When a timer output occurs, an output from inverter A103 comes to L level; field effect transistor Q103 is turned ON; field effect transistor Q104 is turned OFF; and the other end of capacitor 202 (on -side in the figure) is connected to low voltage power supply VCC1 via field effect transistor Q103. In this configuration, voltage VC charged to capacitor 202 is added to low voltage power VCC1; and the resulting power voltage boosted to (VCC1+VC) =VCC2 is supplied to output amplifier 17.

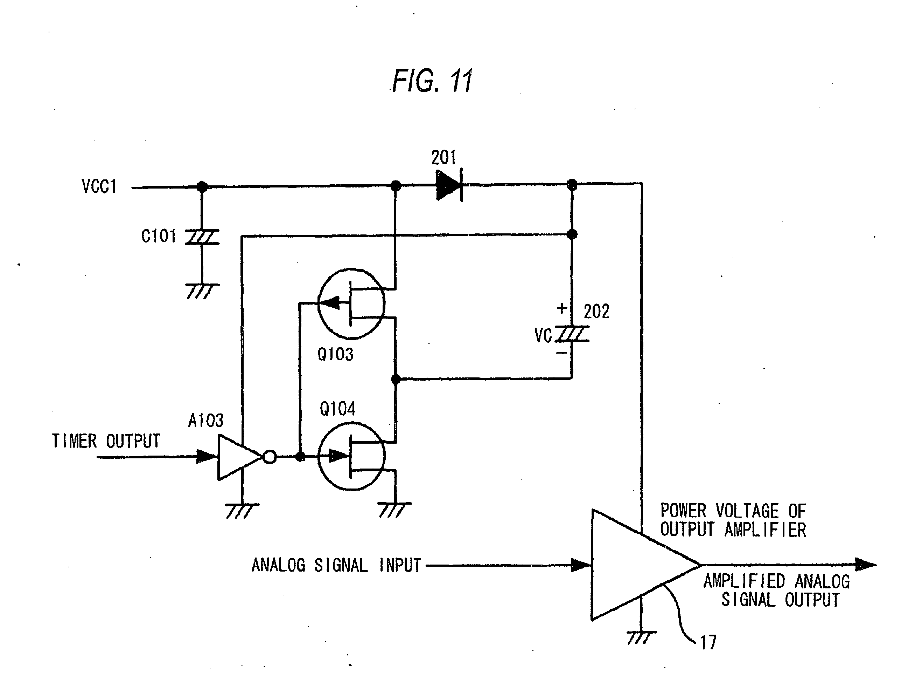

In the intensifier (booster) shown in Fig. 11 as a second example, a power source is provided to inverter A103 from a cathode of diode 201. The rest of the configurations are identical to those shown in Fig. 10 as the first example.

The second example allows the drive voltage of field effect transistor Q103 to be increased by obtaining a power source to inverter A103, which drives P-channel field effect transistor Q103, from the power voltage boosted to VCC1+VC. This makes it possible to reduce the ON resistance of the switching transistor and to switch the power voltages of output amplifier 17 at a high speed.

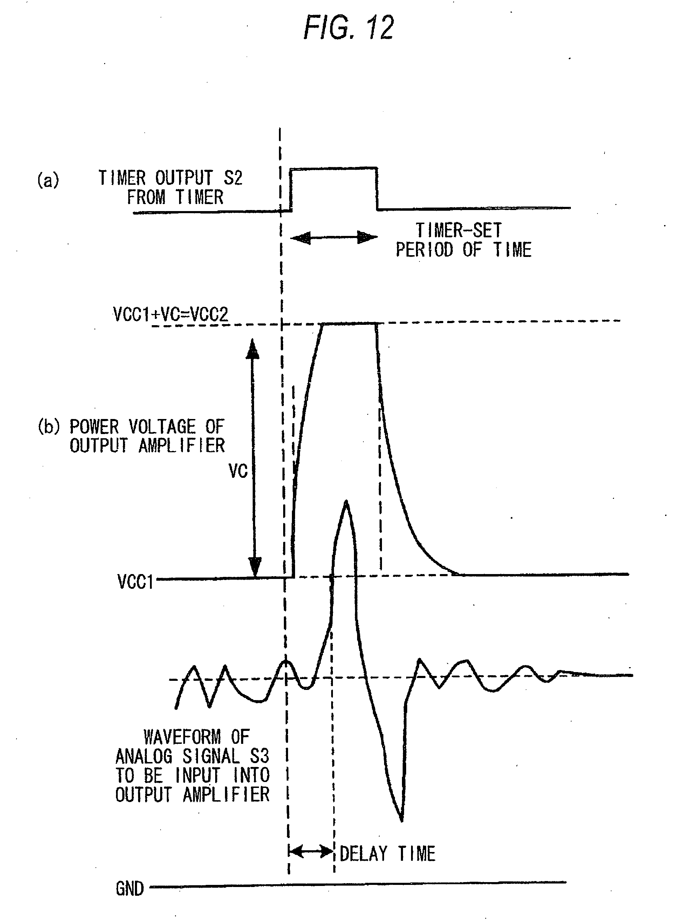

As shown in Fig. 12 (a), as with the first example, timer 15 outputs timer output S2. Based on this timer output, as shown in Fig. 12 (b), intensifier (booser) 20 switches the power voltage of output amplifier 17 from low voltage power VCC1 to the power voltage boosted to VCC1+VC only during a timer-set period of time.

Here, as shown in the lower section of Fig. 12 (b), analog signal S3 is supplied to output amplifier 17 as an OFDM signal, which is delayed by delay unit 12 for a predetermined period and is D/A-converted by D/A converter 13. Through the above-noted power voltage increase, the power voltage of output amplifier 17 is set high while the amplitude of an output signal is large. This makes it possible to amplify even large-amplitude signals with no distortion, thereby securing a sufficient dynamic range and maintaining linearity of the amplifier circuit.

In the third example as described above, as with the first example, through power voltage increase in which the power voltage of the output amplifier is increased only during a predetermined period elapsed after an output signal has exceeded a predetermined level, a simple configuration can be used to increase the power voltage of the output amplifier only when the amplitude of an output signal is large. This makes it possible to secure linearity even for large-amplitude signals at peak and to reduce power consumption.

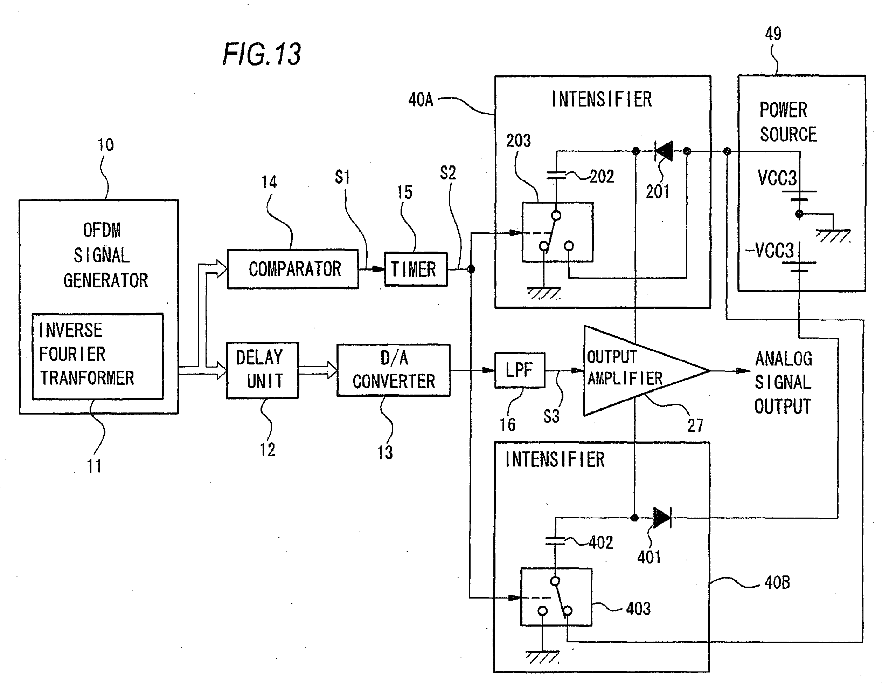

The OFDM signal output circuit described in the fourth example, as shown in Fig. 13, includes: OFDM signal generator 10 including inverse Fourier transformer 11; delay unit 12; D/A converter 13; comparator 24; timer 15; LPF (low pass filter) 16; output amplifier 27 that is operated by positive and negative power supplies; power source 49 that supplies positive and negative power voltages VCC3 and -VCC3; and intensifiers (boosters) 40A and 40B that intensify positive and negative power voltages, respectively.

Intensifiers (boosters) 40A and 40B have a function of switching positive and negative power voltages to be supplied to output amplifier 27, in accordance with timer outputs from timer 15. Intensifier (booster) 40A for boosting a positive power voltage is identical to intensifier (booster) 20 shown in Fig. 8. Intensifier (booster) 40B for boosting a negative power voltage includes: diode 401 provided between the negative power terminal of output amplifier 27 and negative low voltage power supply -VCC3; capacitor 402, which is connected at one end to the connecting point (on the anode side of diode 401) between the negative power terminal of output amplifier 27 and diode 401, and which reduces negative low voltage power -VCC3 output from power source 49; and switching circuit 403 that switches the connection to the other end of capacitor 402 to the output or the ground of power source 49, based on timer outputs from timer 15.

While no timer output is being generated, switching circuit 203 of intensifier (booster) 40A connects the other end of capacitor 202 to the ground potential (GND), and a power charge is provided to capacitor 202 at a voltage level derived by subtracting the forward voltage drop for diode 201 from low voltage power VCC3. Further, switching circuit 403 of intensifier (booster) 40B connects the other end of capacitor 402 to positive low voltage power VCC3 of power source 49. This configuration provides a power charge to capacitor 402, to which is applied a voltage level derived by subtracting the forward voltage drop for diode 401 from the voltage difference between positive low voltage power VCC3 and negative low voltage power -VCC3.

Here, positive low voltage power VCC3 is supplied to the positive power terminal of output amplifier 27; and negative low voltage power -VCC3 is supplied to the negative power terminal of output amplifier 27. Further, positive low voltage power VCC3 and negative low voltage power -VCC3 are set high enough to amplify a signal to be input to output amplifier 27 with low distortion when its amplitude is small.

While a timer output is being generated, switching circuit 203 of intensifier (booster) 40A connects the other end of capacitor 202 to the output of power source 49; the voltage charged to capacitor 202 is added to low voltage power VCC3; and the boosted power voltage is supplied to the positive power terminal of output amplifier 27. Further, switching circuit 403 of intensifier (booster) 40B connects the other end of capacitor 402 to the ground potential. This reduces the voltage of the negative power terminal of output amplifier 27 by a margin equal to the voltage charged to capacitor 402 against the ground potential, thereby supplying the boosted power voltage to the negative power terminal.

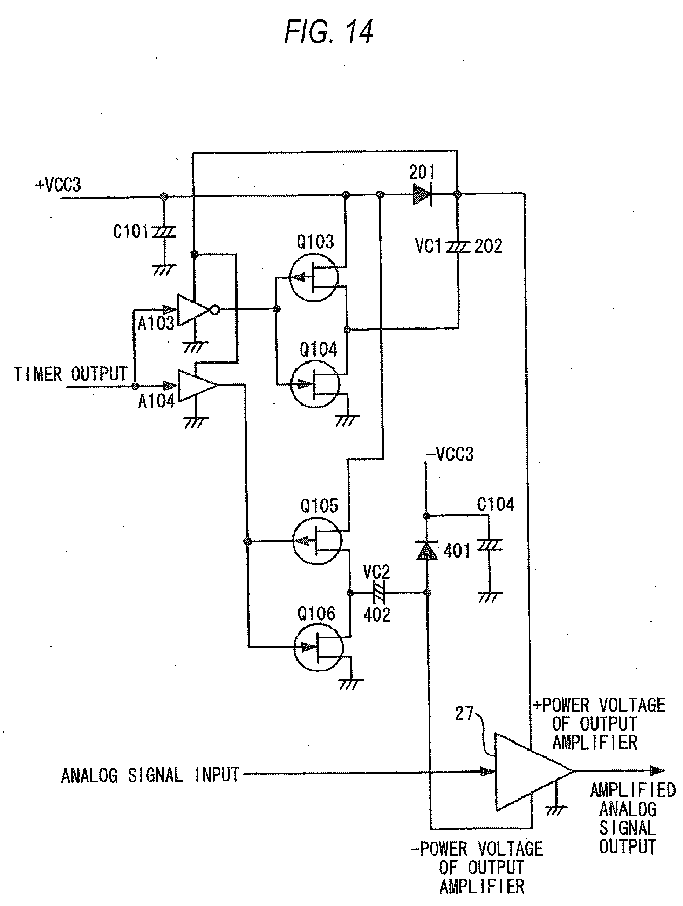

In Fig. 14, switching circuit 203 includes: inverter A103; P-channel field effect transistor Q103; and N-channel field effect transistor Q104. Switching circuit 403 includes: buffer A104; P-channel field effect transistor Q105 and N-channel field effect transistor Q106. Low voltage power VCC3 is supplied to inverter A103 and buffer A104 as a power source.

While no timer output is being generated, an output from inverter A103 is at H level; field effect transistor Q103 is turned OFF; and field effect transistor Q104 is turned ON. Voltage VC1 is charged to capacitor 202 at a voltage level derived by subtracting the forward voltage drop VD for diode 201 from positive low voltage power VCC3. An output from buffer A104 is at L level; field effect transistor Q105 is turned ON; and field effect transistor Q106 is turned OFF. When field effect transistor Q105 is turned ON, voltage VC2 is charged to capacitor 402 at a voltage level derived by subtracting the forward voltage drop VD for diode 401 from VCC3 - (-VCC3)=2VCC3, which is the difference between the positive and negative low voltage power. At this stage, voltage VC2=VCC3+VC1 is obtained.

When a timer output occurs, an output from inverter A103 comes to L level; field effect transistor Q103 is turned ON; and field effect transistor Q104 is turned OFF. When field effect transistor Q103 is turned ON, the voltage at the other end of capacitor 202 is increased to positive low voltage power VCC3, thereby adding voltage VC1 charged to capacitor 202 to positive low voltage power VCC 3; and thus the power voltage supplied to the positive power terminal of output amplifier 27 is boosted to VCC3+VC1=VCC4. Further, an output from buffer A104 comes to H level; field effect transistor Q105 is turned OFF; and field effect transistor Q106 is turned ON. When field effect transistor Q106 is turned ON, the power voltage supplied to the negative power terminal of output amplifier 27 is reduced by a margin equal to voltage VC2, which is charged to capacitor 402 against the ground potential; and the power voltage is boosted to -VC2=-(VCC3+VC1)=-VCC4.

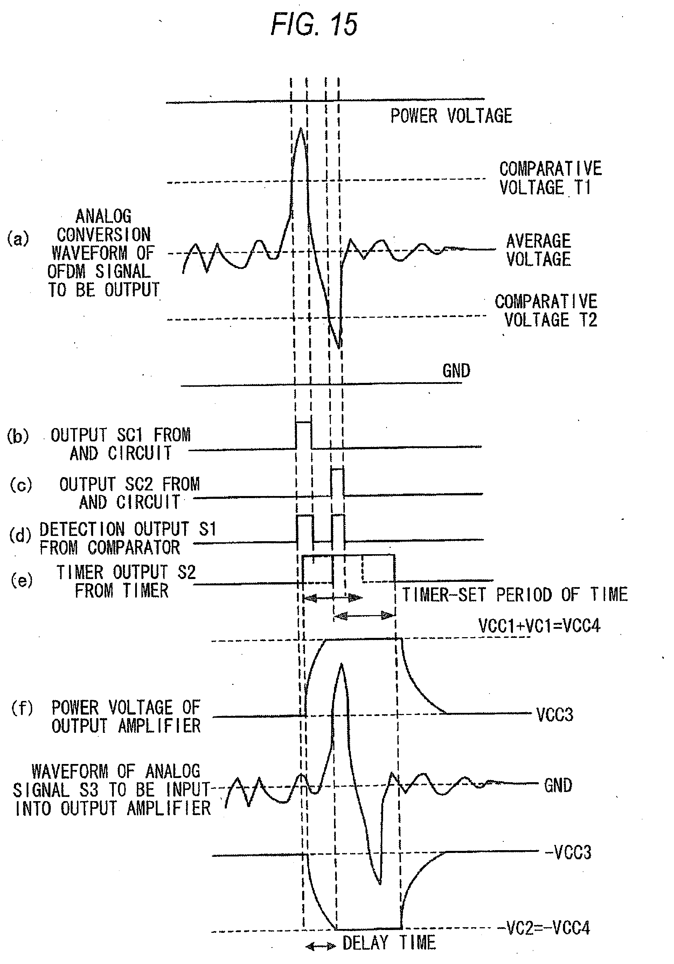

Fig. 15 (a) shows the analog conversion waveform of an OFDM signal to be output, as with the second example. As shown in Fig. 15 (b), AND circuit 244 of comparator 24 outputs output SC1 at H level only while the amplitude of an analog conversion waveform is above comparative voltage T1. As shown in Fig. 15 (c), AND circuit 243 of comparator 24 outputs output SC2 at H level only while the amplitude of an analog conversion waveform is below comparative voltage T2. As shown in Fig. 15 (d), OR circuit 245 of comparator 24 performs logical OR operation on outputs shown in Figs. 15 (b) and 15 (c); and the sum is output as detection output S1 from comparator 24.

As shown in Fig. 15 (e), timer 15 generates timer output S2 based on a detection output from comparator 24. Based on this timer output, as shown in Fig. 15 (f), intensifiers (boosters) 40A and 40B switch the power voltage of output amplifier 27 from low voltage power VCC3 and -VCC3 to the voltage boosted to high voltage power VCC4 and -VCC4 only during a timer-set period of time.

Here, as shown in the middle section of Fig. 15 (f), analog signal S3 is supplied to output amplifier 27 as an OFDM signal, which is delayed by delay unit 12 for a predetermined period and is D/A-converted by D/A converter 13. Through the above-noted power voltage increase, the power voltage of output amplifier 27 is set high while the amplitude of an output signal is large. This makes it possible to amplify even large-amplitude signals with no distortion, thereby securing a sufficient dynamic range and maintaining linearity of the amplifier circuit.

In the fourth example as described above, as with the second example, through power voltage increase in which the power voltage of the output amplifier is increased during a predetermined period elapsed after an output signal has exceeded a predetermined level, a simple configuration can be used to increase the power voltage of the output amplifier only when the amplitude of an output signal is large. This makes it possible to secure linearity even for large-amplitude signals at peak and to reduce power consumption.

Further, switching simultaneously the positive and negative voltages of output amplifier 27 keeps the DC bias point of output amplifier 27 unchanged for large and small amplitudes, thereby preventing a shift in the operating point or an occurrence of a transient when the power voltages are switched. In regard to the waveform of an output signal, this also reduces the voltage difference between the power voltage and the voltage of the output signal waveform, both in the positive and negative amplitudes, thereby further reducing the loss in output amplifier 27.

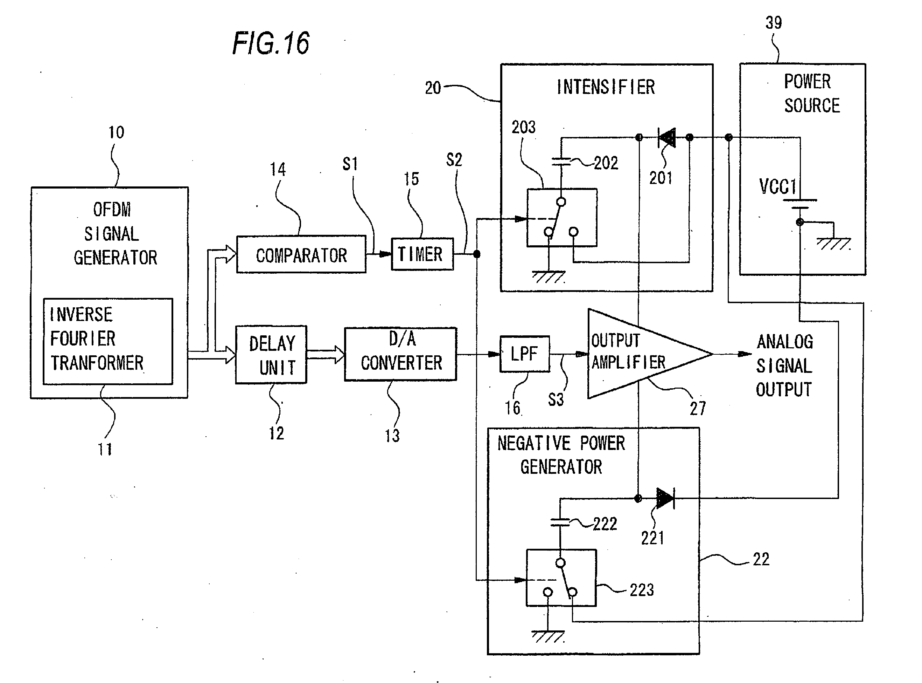

The OFDM signal output circuit described in the invention embodiment, as shown in Fig. 16, includes: OFDM signal generator 10 including inverse Fourier transformer 11; delay unit 12; D/A converter 13; comparator 24; timer 15; LPF (low pass filter) 16; output amplifier 37 that is operated by a single power supply, and positive and negative power supplies; power source 39; and intensifier (booster) 20 that boosts a positive power voltage; and negative power generator 22 that generates a negative power voltage.

Power source 39 includes only low voltage power supply VCC1. Intensifier (booster) 20 for boosting a positive power voltage is identical to intensifier (booster) 20 shown in Fig. 8. Negative power generator 22 includes: diode 221 provided between the negative power terminal of output amplifier 37 and the ground; capacitor 222, which is connected at one end to the connecting point (on the anode side of diode 221) between the negative power terminal of output amplifier 37 and diode 221; and switching circuit 223 that switches the connection to the other end of capacitor 222 to the output or the ground of power source 39, based on timer outputs from timer 15.

While no timer output is being generated, switching circuit 203 of intensifier (booster) 20 connects the other end of capacitor 202 to the ground potential; and a power charge is provided to capacitor 202 at a voltage level derived by subtracting the forward voltage drop for diode 201 from low voltage power VCC1. Further, switching circuit 223 of negative power generator 22 connects the other end of capacitor 222 to low voltage power supply VCC1 of power source 39. This configuration provides a power charge to capacitor 222, to which is applied a voltage level derived by subtracting the forward voltage drop for diode 221 from low voltage power VCC1.

Here, low voltage power VCC1 is supplied to the positive power terminal of output amplifier 37; the negative power terminal is connected to the ground via diode 221; and its voltage comes to nearly equal to the ground potential. Positive low voltage power VCC1 is set high enough to amplify a signal to be input into output amplifier 37 with no distortion when its amplitude is small.

While a timer output is being generated, switching circuit 203 of intensifier (booster) 20 connects the other end of capacitor 202 to the output of power source 39; the voltage charged to capacitor 202 is added to low voltage power VCC1; and the boosted power voltage is supplied to the positive power terminal of output amplifier 37. Further, switching circuit 223 of negative power generator 22 connects the other end of capacitor 222 to the ground potential. This reduces the power voltage supplied to the negative power terminal of output amplifier 37 by a margin equal to the voltage charged to capacitor 222 vis-à-vis the ground potential, thereby supplying negative power voltage.

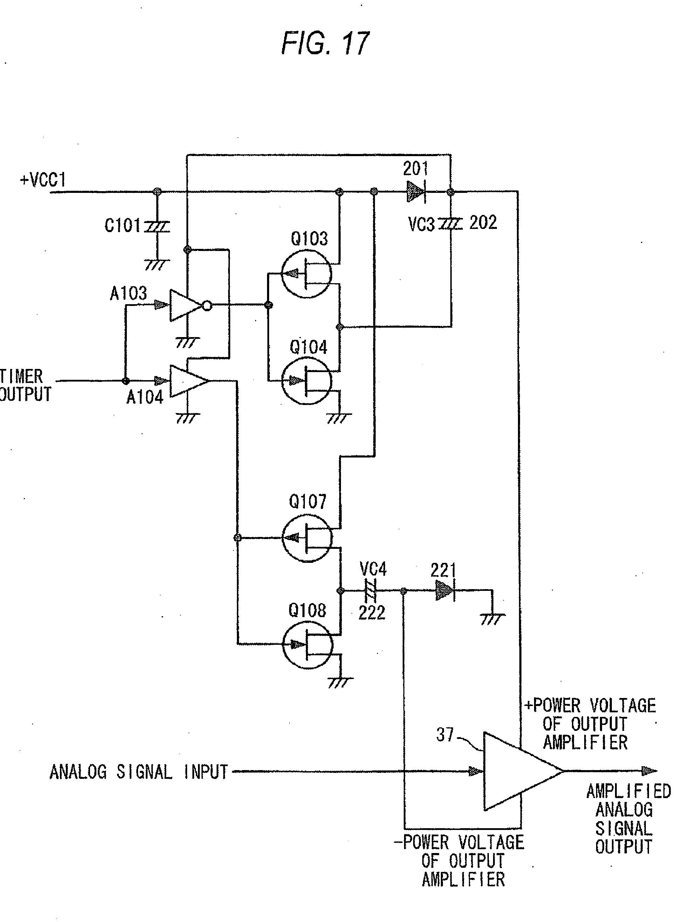

In Fig. 17, switching circuit 203 includes: inverter A103; P-channel field effect transistor Q103; and N-channel field effect transistor Q104. Switching circuit 223 includes: buffer A104; P-channel field effect transistor Q107 and N-channel field effect transistor Q108. Low voltage power VCC1 is supplied to inverter A103 and buffer A104 as a power source.

While no timer output is being generated, an output from inverter A103 is at H level; field effect transistor Q103 is turned OFF; and field effect transistor Q104 is turned ON. When field effect transistor Q104 is turned ON, voltage VC3 is charged to capacitor 202 at a voltage level derived by subtracting the forward voltage drop VD for diode 201 from low voltage power VCC1. Further, an output from buffer A104 is at L level; field effect transistor Q107 is turned ON; and field effect transistor Q108 is turned OFF. When field effect transistor Q107 is turned ON, voltage VC4 is charged to capacitor 222 at a voltage level derived by subtracting the forward voltage drop VD for diode 221 from low voltage power VCC1. At this stage, voltage VC4=VC3 is obtained.

When a timer output occurs, an output from inverter A103 comes to L level; field effect transistor Q103 is turned ON; and field effect transistor Q104 is turned OFF. When field effect transistor Q103 is turned ON, the voltage at the other end of capacitor 202 is increased to low voltage power VCC1, thereby adding voltage VC3 charged to capacitor 202 to low voltage power VCC1; and the power voltage supplied to the positive power terminal of output amplifier 37 is boosted to VCC1+VC3. Further, an output from buffer A104 comes to H level; field effect transistor Q107 is turned OFF; and field effect transistor Q108 is turned ON. When field effect transistor Q108 is turned ON, the power voltage supplied to the negative power terminal of output amplifier 37 is reduced by a margin equal to voltage VC4 charged to capacitor 222 vis-à-vis the ground potential, thereby supplying negative voltage -VC4=-VC3.

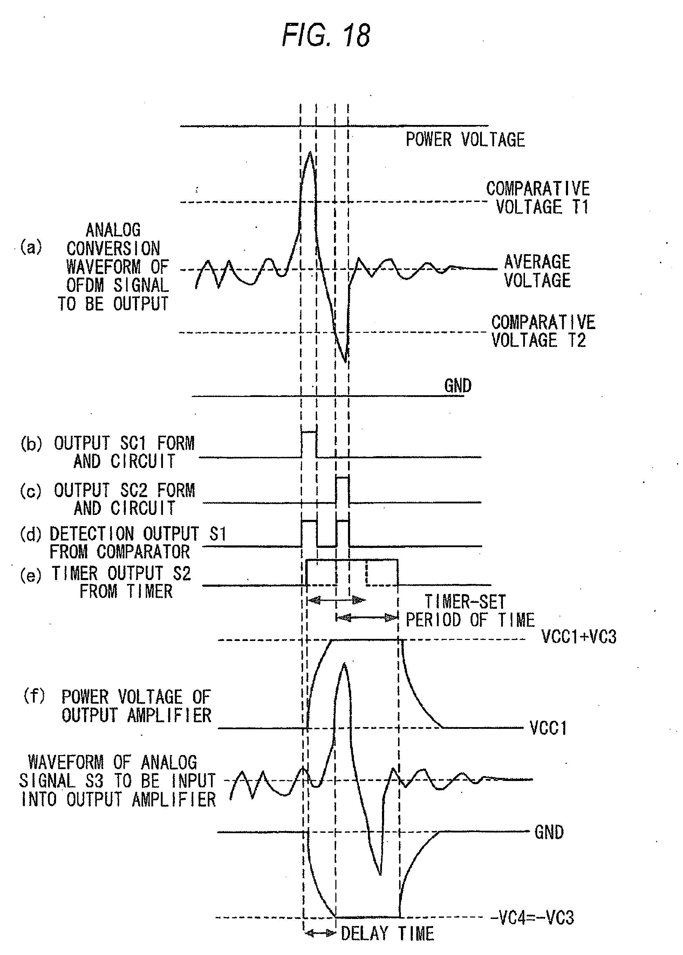

Fig. 18 (a) shows the analog conversion waveform of an OFDM signal to be output, as with the second example. As shown in Fig. 18 (b), AND circuit 244 of comparator 24 outputs output SC1 at H level only while the amplitude of an analog conversion waveform is above comparative voltage T1. As shown in Fig. 18 (c), AND circuit 243 of comparator 24 outputs output SC2 at H level only while the amplitude of an analog conversion waveform is below comparative voltage T2. As shown in Fig. 18 (d), OR circuit 245 of comparator 24 performs logical OR operation on outputs shown in Figs. 18 (b) and 18 (c); and the sum is output as detection output S1 from comparator 24.

As shown in Fig. 18 (e), timer 15 generates timer output S2 based on a detection output from comparator 24. Based on this timer output, as shown in Fig. 18 (f), intensifier (booster) 20 and positive power generator 22 switch the power voltage of output amplifier 37 from low voltage power VCC1 and approximately 0V equal to nearly ground potential to voltage VCC1+VC3 and -VC3 only during a timer-set period of time.

Here, as shown in the middle section of Fig. 18 (f), analog signal S3 is supplied to output amplifier 37 as an OFDM signal, which is delayed by delay unit 12 for a predetermined period and is D/A-converted by D/A converter 13. Through the above-noted power voltage switch, the power voltage of output amplifier 37 is set high while the amplitude of an output signal is large. This makes it possible to amplify even large-amplitude signals with no distortion, thereby securing a sufficient dynamic range and maintaining linearity of the amplifier circuit.

In the invention embodiment as described above, as with the second example, through power voltage switch in which the power voltage of the output amplifier is increased during a predetermined period elapsed after an output signal has exceeded a predetermined level, a simple configuration can be used to increase the power voltage of the output amplifier only when the amplitude of an output signal is large. This makes it possible to secure linearity of the amplifier circuit even for large-amplitude signals at peak and to reduce power consumption. Further, switching simultaneously the positive and negative voltages of output amplifier 37 keeps the DC bias point of output amplifier 37 unchanged for large and small amplitudes, thereby preventing a shift in the operating point or an occurrence of a transient when the power voltages are switched. In regard to the waveform of an output signal, this also reduces the voltage difference between the power voltage and the voltage of the output signal waveform, both in the positive and negative amplitudes, thereby further reducing the loss in output amplifier 37.

Further, in the invention embodiment, it is possible to intensify, by single low voltage power VCC1, the power voltage of output amplifier 37 in both positive and negative directions. This can simplify the power source configuration in comparison to the second and fourth examples.

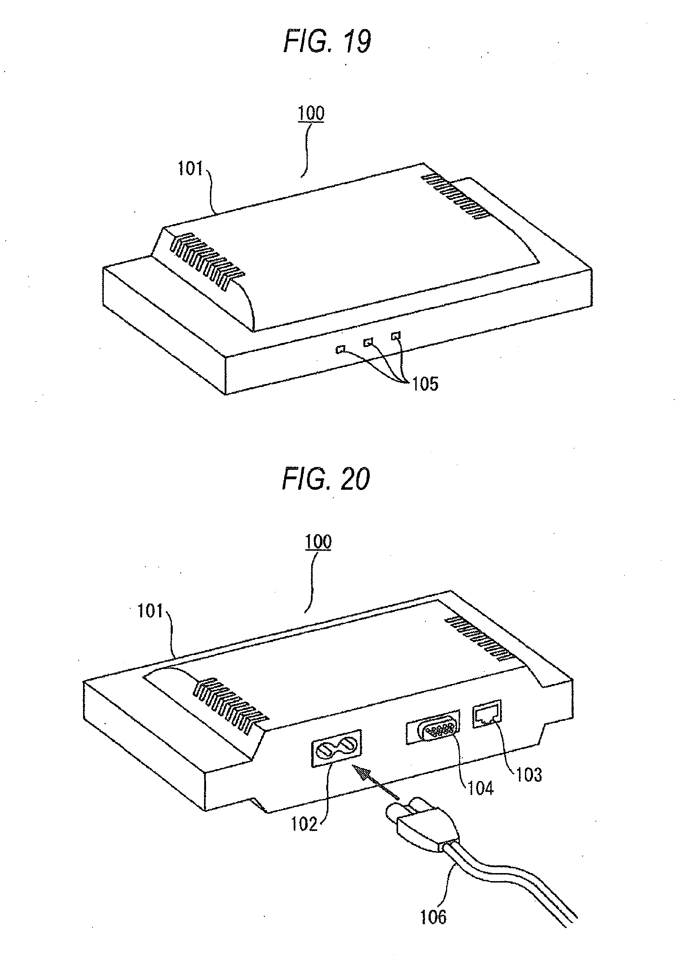

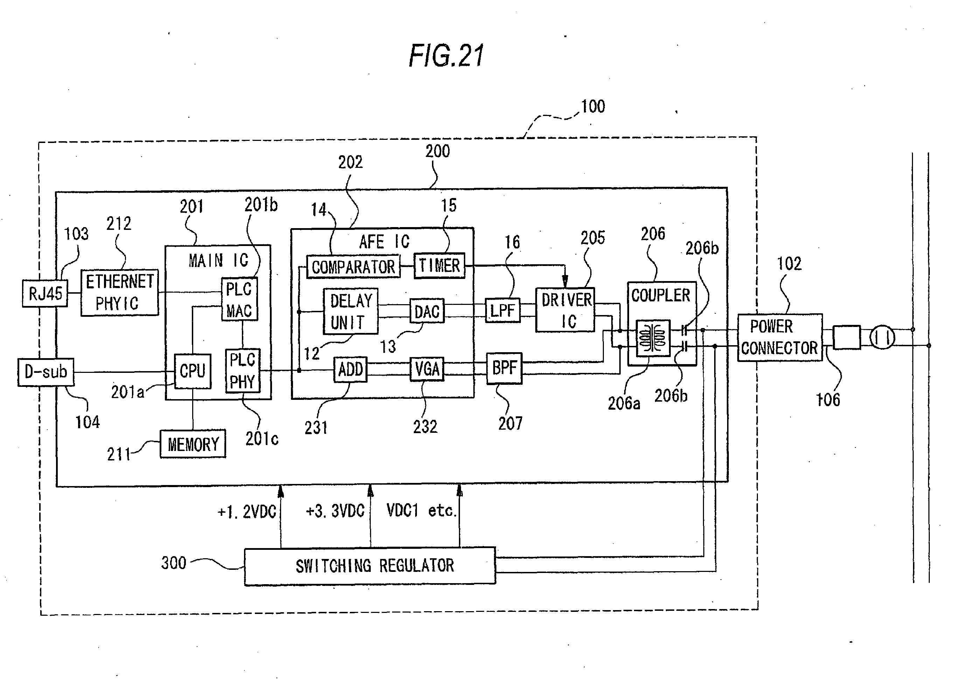

The following describes a configuration example of a multi-carrier communication apparatus, which is a power line communication apparatus including the OFDM signal output circuit. Figs. 19 through 21 show specific configuration examples of the multi-carrier communication apparatus. Fig. 19 is an anterior perspective view of the multi-carrier communication apparatus; Fig. 20 is a rear perspective view of the multi-carrier communication apparatus; and Fig. 21 is a block diagram illustrating a configuration example of an electric circuit of the multi-carrier communication apparatus.

Multi-carrier communication apparatus 100, which includes the OFDM signal output circuit is a communication terminal that performs power line communication. More specifically, multi-carrier communication apparatus 100 is configured as a modem (a PLC modem). Of course, the multi-carrier communication apparatus can be configured as other devices, such an electric appliance equipped with a modem (e.g., a home appliance such as a TV).

Multi-carrier communication apparatus 100 houses electric circuit module 200 shown in Fig. 21, in chassis 101 shown in Figs. 19 and 20. As shown in Fig. 19, display 105 including LEDs (Light Emitting Diodes) are provided on the front side of chassis 101. Further, as shown in Fig. 20, power connector 102, modular jack 103 for LAN (Local Area Network) cable connection, such as RJ45, and Dsub connector 104 for serial cable connection, are provided on the rear side of chassis 101. AC cord 106, such as a parallel cable or the like, is connected to power connector 102. A LAN cable (not shown) is connected to modular jack 103. A serial cable (not shown) is connected to Dsub connector 104.

As shown in Fig. 21, multi-carrier communication apparatus 100 houses circuit module 200 and switching regulator 300. Switching regulator 300 receives commercial alternating current (100V AC) from a power line via power connector 102; generates and supplies voltages of various levels, such as +1.2V, +3.3V, VCC1 (e.g., +6V), to circuit module 200.

Circuit module 200 transmits/receives data to/from another terminal by using multi-carrier signals such as OFDM signals. Circuit module 200 includes main IC (Integrated Circuit) 201, AFE (Analog Front End) IC 202, low pass filter (LPF) 16, driver IC 205, coupler 206, band pass filter (BPF) 207, memory 211 and Ethernet PHY IC 212.

Main IC 201 includes: CPU (Central Processing Unit) 201 a; PLC MAC (Power Line Communication Media Access Control) block 201b; and PLC PHY (Power Line Communication Physic layer) block 201 c. AFE IC 202 includes: delay unit 12 of the above-described OFDM signal output circuit; D/A converter (DAC) 13; comparator 14; timer 15; A/D converter (ADC) 231 of the OFDM signal input circuit; and variable gain amplifier (VGA) 232. Driver IC 205 includes: output amplifier 17; voltage switcher 18; intensifier (booster) 20 or the like. Coupler 206 includes coil transformer 206a and capacitor 206b.

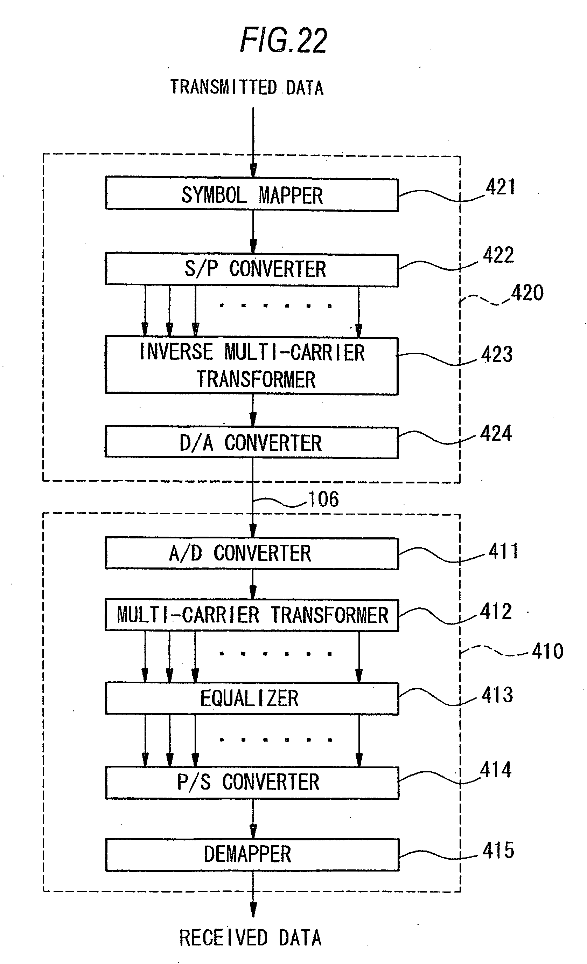

Fig. 22 is a functional block for parts of circuit module 200 shown in Fig. 21 that are specifically related to power line communication.

Receiver 410 includes: A/D converter 411; multi-carrier transformer 412 that performs predetermined time-frequency transform, such as a Fourier transformer (FFT), a wavelet transformer (DWT) or the like; equalizer 413 that corrects received signals to cancel out effects of a transmission line; P/S converter 414 that converts parallel data into serial data; and demapper 415 that converts mapped symbol data into bit data as received signals. PLC PHY block 201 c of main IC 201 shown in Fig. 21 is where functions of multi-carrier transformer 412, equalizer 413, P/S converter 414 and demapper 415 are realized; and A/D converter 231 of AFE IC 202 is where a function of A/D converter 411 is realized.

Transmitter 420 includes: symbol mapper 421 that performs symbol mapping by converting bit data as transmitted signals into symbol data; S/P converter 422 that converts serial data into parallel data; inverse multi-carrier transformer 423 that performs predetermined frequency-time transform, such as an inverse Fourier transformer (IFFT) or an inverse wavelet transformer (IDWT); and D/A converter 424. PLC PHY block 201c of main IC 201 shown in Fig. 21 is where functions of symbol mapper 421, S/P converter 422 and inverse multi-carrier transformer 423 are realized. In this example, inverse multi-carrier transformer 423 corresponds to inverse Fourier transformer 11 of OFDM signal generator 10; and D/A converter 424 corresponds to D/A converter 13.

It is possible for the power source to share a power source with a digital circuit in order to derive low voltage power to be supplied to the output amplifier. Particularly, in a configuration including the intensifier (booster), low voltage is sufficient as the power voltage of the power source. This thus allows the power source and the digital circuit to share a power source, thereby eliminating the need for a separate power source exclusively prepared for an analog circuit.

Further, as with the configuration shown in Fig. 21, it is possible to build into a driver IC a circuit including a switching element such as a field effect transistor, which is provided as a switcher of a voltage switcher or an intensifier (booster). In this case, it becomes possible to reduce an on resistance of the switching element and lower an absolute value of a stray capacitance, thereby enabling a high-speed switching operation. In addition, such high-speed switching can reduce the amount of a delay in an OFDM signal by the delay unit, thereby reducing the number of delay circuit elements (D flip-flop shown in Figs. 2 and 6) as well as the circuit size.

As described above, in the signal output circuit a simple configuration can be used to increase the power voltage of the output amplifier only when the amplitude of an output signal is large, by switching or boosting power voltages so that the power voltage of the output amplifier is increased only during a predetermined period elapsed after an output signal has exceeded a predetermined level. This makes it possible to, secure linearity of an amplifier circuit even for an amplitude peak and to reduce power consumption of the output amplifier.

In power line communication in particular, since power lines are used as transmission lines, a signal attenuation is large and a noise level is high in comparison to communication using stable transmission lines such as coaxial cables. Therefore, the level (amplitude) of an output signal needs to be high in order to improve the S/N ratio, which contributes to an increase in power consumption. Moreover, the level of an output signal needs to be further increased in order to increase coverage (communication distance). In such cases, since the signal output circuit is designed to increase the level of an output signal by increasing power voltage when the output signal exceeds a predetermined level during communication, the circuit can improve the S/N ratio and thus increase coverage while suppressing an increase in power consumption, even when the signal is attenuated or the noise level is increased.

### Industrial Applicability

The present invention can reduce power consumption while making it possible to secure linearity even for large-amplitude output signals with a simple configuration.

## Claims

1. A signal output circuit for outputting an output signal having amplitude, the signal output circuit comprising:
a detector (14) that detects whether or not the amplitude of the output signal exceeds a predetermined value;
a delay unit (12) that delays the output signal for a predetermined period;
a power source (39) that outputs power voltage;
an intensifier (20) that is connected to the power source (39), charges a first voltage on the basis of the power voltage while the detector (14) detects that the amplitude does not exceed the predetermined value and outputs the power voltage boosted by the charged first voltage when the detector (14) detects that the amplitude exceeds the predetermined value,
an opposite power generator (22) that is connected to the power source (39), charges a second voltage on the basis of the power voltage while the detector (14) detects that the amplitude does not exceed the predetermined value, the second voltage having an opposite sign to the first voltage, and outputs the charged second voltage when the detector (14) detects that the amplitude exceeds the predetermined value; and
an output amplifier (27) that is connected to the intensifier (20) and the opposite power generator (22) and amplifies the output signal delayed by the delay unit (12), receiving the boosted power voltage output from the intensifier (20) and the charged second voltage output from the opposite power generator (22).

2. The signal output circuit according to claim 1, wherein the intensifier (20) further comprises a first capacitor (202) and charges the positive voltage to the first capacitor (202) on the basis of the power voltage while the detector detects that the amplitude does not exceed the predetermined value and outputs the charged first power voltage from the capacitor (202) when the detector (14) detects that the amplitude exceeds the predetermined value, and
the opposite power generator (22) further comprises a second capacitor (222) and charges the second voltage to the second capacitor (222) on the basis of the power voltage while the detector (14) detects that the amplitude does not exceed the predetermined value and outputs the charged second power voltage from the capacitor (222) when the detector (14) detects that the amplitude exceeds the predetermined value.

3. The signal output circuit according to claim 1, wherein the power source (39) outputs positive power voltage.

4. The signal output circuit according to claim 8, wherein the intensifier (20; 40A, 40B) includes:
a diode (201), which is series-connected between the power source (19;
29A, 29B) and a power terminal of the output amplifier (17; 27; 37);
a capacitor (202), which is connected at one end to the connecting point between the diode (201) and the power terminal of the output amplifier (17; 27; 37); and
a switching circuit (203), which switches a voltage at the other end of the capacitor (202) to a different voltage, in accordance with the amplitude information.

5. The signal output circuit according to any of claim 6 through 9 that uses an OFDM (Orthogonal Frequency Division Multiplexing) signal generated through OFDM as the output signal, outputs the amplification information of the OFDM signal and amplifies the OFDM signal.

6. A communication apparatus (100) including the signal output circuit according to one of claim 1 through 6 in a transmitter (420).

7. The communication apparatus (100) according to claim 11, wherein the transmitter (420) has a communication function of using a power line (106) as a transmission line for power line communication.

8. A signal output control method for outputting an output signal having amplitude, the signal output control method comprising:
detecting whether or not the amplitude of the output signal exceeds a predetermined value;
delaying the output signal for a predetermined period;
outputting a power voltage;
charging a first voltage and a second voltage on the basis of the power voltage while it is detected that the amplitude of the output signal does not exceed the predetermined value, wherein the second voltage has an opposite sign to the first voltage, outputting the power voltage boosted by the first voltage when the amplitude exceeding the predetermined value is detected,
outputting the second voltage when the amplitude exceeding the predetermined value is detected,
amplifying the delayed output signal by an amplifier receiving the boosted power voltage and the second power voltage.

## Patentansprüche

1. Signalausgabeschaltung zum Ausgeben eines Ausgabesignals mit einer Amplitude, wobei die Signalausgabeschaltung umfasst:
einen Detektor (14), der erfasst, ob die Amplitude des Ausgabesignals einen vorbestimmten Wert überschreitet,
eine Verzögerungseinheit (12), die das Ausgabesignal um eine vorbestimmte Zeitspanne verzögert,
eine Leistungsquelle (39), die eine Leistungsspannung ausgibt,
einen Intensivierer (20), der mit der Leistungsquelle (39) verbunden ist, eine erste Spannung auf Basis der Leistungsspannung speichert, während der Detektor (14) erfasst, dass die Amplitude den vorbestimmten Wert nicht überschreitet, und die Leistungsspannung, die mit der gespeicherten ersten Spannung verstärkt ist, ausgibt, wenn der Detektor (14) erfasst, dass die Amplitude den vorbestimmten Wert überschreitet,
einen Gegenspannungsgenerator (22), der mit der Leistungsquelle (39) verbunden ist, eine zweite Spannung auf Basis der Leistungsspannung speichert, während der Detektor (14) erfasst, dass die Amplitude den vorbestimmten Wert nicht überschreitet, wobei die zweite Spannung ein Vorzeichen aufweist, das dem der ersten Spannung entgegengesetzt ist, und die gespeicherte zweite Spannung ausgibt, wenn der Detektor (14) erfasst, dass die Amplitude den vorbestimmten Wert überschreitet, und
einen Ausgabeverstärker (27), der mit dem Intensivierer (20) und dem Gegenspannungsgenerator (22) verbunden ist und das Ausgabesignal, das von der Verzögerungseinheit (12) verzögert wurde, verstärkt, wobei der Ausgabeverstärker die verstärkte Leistungsspannungsausgabe aus dem Intensivierer (20) und die gespeicherte zweite Spannungsausgabe aus dem Spannungsgenerator (22) empfängt.

2. Signalausgabeschaltung nach Anspruch 1,
wobei der Intensivierer (20) ferner einen ersten Kondensator (202) aufweist und die positive Spannung in dem ersten Kondensator (202) auf Basis der Leistungsspannung speichert, während der Detektor erfasst, dass die Amplitude den vorbestimmten Wert nicht überschreitet, und die gespeicherte erste Leistungsspannung aus dem Kondensator (202) ausgibt, wenn der Detektor (14) erfasst, dass die Amplitude den vorbestimmten Wert überschreitet, und
wobei der Gegenleistungsgenerator (22) ferner einen zweiten Kondensator (222) umfasst und die zweite Spannung in dem zweiten Kondensator (222) auf Basis der Leistungsspannung speichert, während der Detektor (14) erfasst, dass die Amplitude den vorbestimmten Wert nicht überschreitet, und die gespeicherte zweite Leistungsspannung aus dem Kondensator (222) ausgibt, wenn der Detektor (14) erfasst, dass die Amplitude den vorbestimmten Wert überschreitet.

3. Signalausgabeschaltung nach Anspruch 1,
wobei die Leistungsquelle (39) eine positive Leistungsspannung ausgibt.

4. Signalausgabeschaltung nach Anspruch 8,
wobei der Intensivierer (20, 40A, 40B) umfasst:
eine Diode (201), die in Serie zwischen der Leistungsquelle (19, 29A, 29B) und einem Leistungsanschluss des Ausgabeverstärkers (17, 27, 37) verbunden ist,
einen Kondensator (202), der an einem Ende mit dem Verbindungspunkt zwischen der Diode (201) und dem Leistungsanschluss des Ausgabeverstärkers (17, 27, 37) verbunden ist, und
einer Schalt-Schaltung (203), die eine Schaltung an dem anderen Ende des Kondensators (202) entsprechend der Amplitudeninformation zu einer anderen Spannung umschaltet.

5. Signalausgabeschaltung nach einem der Ansprüche 6 bis 9,
die ein OFDM-Signal (Orthogonal-Frequency-Division-Multiplexing), das durch OFDM erzeugt wurde, als das Ausgabesignal verwendet, die Verstärkungsinformation OFDM-Signals ausgibt und das OFDM-Signal verstärkt.

6. Kommunikationsvorrichtung (100) mit der Signalausgabeschaltung nach einem der Ansprüche 1 bis 6 in einem Sender (420).

7. Kommunikationsvorrichtung (100) nach Anspruch 11, wobei der Sender (420) eine Kommunikationsfunktion des Verwendens einer Stromleitung (106) als einer Sendeleitung für Stromleitungskommunikation aufweist.

8. Signalausgabesteuerverfahren zum Ausgeben eines Ausgabesignals mit einer Amplitude, wobei das Signalausgabesteuerverfahren umfasst:
Erfassen, ob die Amplitude des Ausgabesignals einen vorbestimmten Wert überschreitet,
Verzögern des Ausgabesignals um eine vorbestimmte Zeitdauer,
Ausgeben einer Leistungsspannung,
Speichern einer ersten Spannung und einer zweiten Spannung auf Basis der Leistungsspannung, während es erfasst wird, dass die Amplitude des Ausgabesignals den vorbestimmten Wert nicht überschreitet, wobei die zweite Spannung ein Vorzeichen aufweist, das dem der ersten Spannung entgegengesetzt ist,
Ausgeben der Leistungsspannung, die von der ersten Spannung verstärkt wurde, wenn die Amplitude erfasst wird, die den vorbestimmten Wert überschreitet,
Ausgeben der zweiten Spannung, wenn die Amplitude erfasst wird, die den vorbestimmten Wert überschreitet,
Verstärken des verzögerten Ausgabesignals durch einen Verstärker, der die erhöhte Leistungsspannung und die zweite Leistungsspannung empfängt.

## Revendications

1. Circuit de sortie de signal destiné à délivrer en sortie un signal de sortie ayant une amplitude, le circuit de sortie de signal comprenant :
un détecteur (14) qui détecte si l'amplitude du signal de sortie dépasse ou non une valeur prédéterminée ;
une unité de retard (12) qui retarde le signal de sortie pendant une période prédéterminée ;
une source d'alimentation (39) qui délivre en sortie une tension d'alimentation ;
un intensificateur (20) qui est connecté à la source d'alimentation (39), charge une première tension sur la base de la tension d'alimentation pendant que le détecteur (14) détecte que l'amplitude ne dépasse pas la valeur prédéterminée et délivre en sortie la tension d'alimentation relevée par la première tension chargée lorsque le détecteur (14) détecte que l'amplitude dépasse la valeur prédéterminée,
un générateur de puissance opposée (22) qui est connecté à la source d'alimentation (39), charge une deuxième tension sur la base de la tension d'alimentation lorsque le détecteur (14) détecte que l'amplitude ne dépasse pas la valeur prédéterminée, la deuxième tension ayant un signe opposé à la première tension, et délivre en sortie la deuxième tension chargée lorsque le détecteur (14) détecte que l'amplitude dépasse la valeur prédéterminée ; et
un amplificateur de sortie (27) qui est connecté à l'intensificateur (20) et au générateur de puissance opposée (22) et amplifie le signal de sortie retardé par l'unité de retard (12), recevant la tension d'alimentation relevée délivrée en sortie depuis l'intensificateur (20) et la deuxième tension chargée délivrée en sortie depuis le générateur de puissance opposée (22).

2. Circuit de sortie de signal selon la revendication 1, dans lequel l'intensificateur (20) comprend en outre un premier condensateur (202) et charge la tension positive au premier condensateur (202) sur la base de la tension d'alimentation lorsque le détecteur détecte que l'amplitude ne dépasse pas la valeur prédéterminée et délivre en sortie la première tension d'alimentation chargée depuis le condensateur (202) lorsque le détecteur (14) détecte que l'amplitude dépasse la valeur prédéterminée, et
le générateur de puissance opposée (22) comprend en outre un deuxième condensateur (222) et charge la deuxième tension au deuxième condensateur (222) sur la base de la tension d'alimentation lorsque le détecteur (14) détecte que l'amplitude ne dépasse pas la valeur prédéterminée et délivre en sortie la deuxième tension d'alimentation chargée depuis le condensateur (222) lorsque le détecteur (14) détecte que l'amplitude dépasse la valeur prédéterminée.

3. Circuit de sortie de signal selon la revendication 1, dans lequel la source d'alimentation (39) délivre en sortie une tension d'alimentation positive.

4. Circuit de sortie de signal selon la revendication 8, dans lequel l'intensificateur (20; 40A, 40B) comporte :
une diode (201), qui est connectée en série entre la source d'alimentation (19; 29A, 29B) et une borne d'alimentation de l'amplificateur de sortie (17; 27; 37) ;
un condensateur (202), qui est connecté à une extrémité au point de connexion entre la diode (201) et la borne d'alimentation de l'amplificateur de sortie (17; 27; 37) ; et
un circuit de commutation (203) qui commute une tension à l'autre extrémité du condensateur (202) à une tension différente, selon l'information d'amplitude.

5. Circuit de sortie de signal selon l'une quelconque des revendications 6 à 9 qui utilise un signal OFDM (Multiplexage par Répartition Orthogonale de la Fréquence) généré par un OFDM comme étant le signal de sortie, délivre en sortie l'information d'amplification du signal OFDM et amplifie le signal OFDM.

6. Appareil de communication (100) comportant le circuit de sortie de signal selon l'une des revendications 1 à 6 dans un émetteur (420).

7. Appareil de communication (100) selon la revendication 11, dans lequel l'émetteur (420) a une fonction de communication permettant d'utiliser une ligne électrique (106) à titre de ligne de transmission pour une communication sur ligne électrique.

8. Procédé de commande de sortie de signal destiné à délivrer en sortie un signal ayant une amplitude, le procédé de commande de sortie de signal comprend les étapes qui consistent :
à détecter si l'amplitude du signal de sortie dépasse ou non une valeur prédéterminée ;
à retarder le signal de sortie pendant une période prédéterminée ;
à délivrer en sortie une tension d'alimentation ;
à charger une première tension et une deuxième tension sur la base de la tension d'alimentation alors qu'on détecte que l'amplitude du signal de sortie ne dépasse pas la valeur prédéterminée, où la deuxième tension a un signe opposé à la première tension, à délivrer en sortie la tension d'alimentation relevée par la première tension lorsque l'amplitude dépassant la valeur prédéterminée est détectée,
à délivrer en sortie la deuxième tension lorsque l'amplitude dépassant la valeur prédéterminée est détectée,
à amplifier le signal de sortie retardé par un amplificateur recevant la tension d'alimentation relevée et la deuxième tension d'alimentation.
